Europäisches Patentamt

European Patent Office

Office européen des brevets

(19)

(11) **EP 1 396 761 A2**

(12) # EUROPEAN PATENT APPLICATION

(43) Date of publication:
**10.03.2004   Bulletin 2004/11**

(51) Int Cl.⁷: **G03F 9/00**

(21) Application number: **03255323.2**

(22) Date of filing: **27.08.2003**

(84) Designated Contracting States:
**AT BE BG CH CY CZ DE DK EE ES FI FR GB GR HU IE IT LI LU MC NL PT RO SE SI SK TR**
Designated Extension States:
**AL LT LV MK**

(30) Priority:  **29.08.2002  EP 02256016**

(71) Applicant: **ASML Netherlands B.V.**
**5503 LA Veldhoven (NL)**

(72) Inventors:
• **Lof, Joeri**
  **5616 BW Eindhoven (NL)**

• **Bijnen, Fransiscus Godefridus Casper**
  **5551 SW Valkenswaard (NL)**
• **Van Buel, Henricus Wilhelmus Maria**
  **5612 EE Eindhoven (NL)**
• **Gui, Cheng-Qun**
  **5685 AZ Best (NL)**

(74) Representative: **Leeming, John Gerard**
**J.A. Kemp & Co.,**
**14 South Square,**
**Gray's Inn**
**London WC1R 5JJ (GB)**

(54) **An alignment tool, a lithographic apparatus, an alignment method and a device manufacturing method**

(57)    An extra optical element is placed in the alignment beam during alignment. The optical element serves to focus the alignment beam onto the substrate alignment mark when it is at a different focal length from the front surface of the substrate.

## Fig. 2

**Description**

The present invention relates to a lithographic projection apparatus comprising:

- a radiation system for providing a projection beam of radiation;
- a support structure for supporting patterning means, the patterning means serving to pattern the projection beam according to a desired pattern;
- a substrate table for holding a substrate having a substrate mark;
- a projection system for projecting the patterned beam onto a target portion of the substrate; and
- an alignment system for detecting alignment between a reference mark and said substrate mark using an alignment beam of radiation.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:

- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired.
- A programmable mirror array. One example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-addressable surface. An alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In both of the situations described hereabove, the patterning means can comprise one of more programmable mirror arrays. More information on mirror arrays as here referred to can be gleaned, for example, from United States Patents US 5,296,891 and US 5,523,193, and PCT patent applications WO 98/38597 and WO 98/33096, which are incorporated herein by reference. In the case of a programmable mirror array, the said support structure may be embodied as a frame or table, for example, which may be fixed or movable as required.
- A programmable LCD array. An example of such a construction is given in United States Patent US 5,229,872, which is incorporated herein by reference. As above, the support structure in this case may be embodied as a frame or table, for example, which may be fixed or movable as required.

For purposes of simplicity, the rest of this text may, at certain locations, specifically direct itself to examples involving a mask and mask table; however, the general principles discussed in such instances should'be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (*e.g.* comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper. In an alternative apparatus commonly referred to as a step-and-scan apparatus — each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792, incorporated herein by reference.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4, incorporated herein by reference.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791, incorporated herein by reference.

Before exposing the substrate, it must be correctly aligned. A mark is provided on the substrate and detected with an alignment system. The substrate mark can be on the front side (the side on which the component parts be etched) or the backside of the substrate. If the substrate mark is on the backside of the substrate the substrate table comprises front-to-backside alignment optics to direct the light beam (the alignment beam) to the bottom side of the substrate. The front-to-backside alignment optics can comprise mirrors embedded into the substrate table.

The substrate mark may not be at the same level as the exposure surface of the substrate. For example, it may be in a pit etched into the substrate, or it may be on the surface of a substrate to which a further substrate has been adhered (leaving the substrate mark uncovered, or etching down to it). The exposure apparatus is engineered to ensure that the projection beam will focus on the front surface of the substrate (which is exposed to form the circuit devices). As the alignment beam often traverses the same optics it will also be in focus on the surface of the substrate and if the substrate mark is not at this surface the alignment beam will therefore be out of focus on the alignment mark. This invention is particularly applicable to substrates used in Micro-Electromechanical Systems, in which the level of the substrate mark can differ from the surface of the substrate quite substantially.

It is an object of the present invention to provide an alignment tool which allows for a variable depth of focus of the alignment beam.

This and other objects are achieved according to the invention in an alignment tool comprising a substrate table for holding a substrate having a substrate mark wherein the substrate mark may be at a different level from the rest of the surface of said substrate and an alignment system for detecting alignment between a reference mark and said substrate mark using an alignment beam of radiation, characterized by an optical element removably positionable in the path of the alignment beam for adjusting the focal plane of said alignment system to focus on said substrate mark at a different level from the rest of the surface of said substrate when detecting alignment.

The optical element is capable of adjusting the focal point of the alignment by up to 2 mm. Optionally, it adjusts the focal plane of the alignment system by at least 0.1 mm.

The optical element focuses the alignment beam onto the substrate mark which is at a different level from the rest of the surface of the substrate and is easily implementable to adjust the focus point. The optical element can adjust the focal plane of the alignment beam by up to 2mm. Plane plates are particularly suitable as optical elements as they are easy to manufacture and don't require accurate axial placement. If the apparatus contains a plurality of interchangeable optical elements one can be chosen from the plurality according to the depth of focus needed for a particular alignment mark. Each of the plurality of optical elements has different thicknesses, or has different optical properties, for example refractive indices. Optionally the optical elements are hollow, each optical element being filled with a fluid having a different refractive index. Alternatively the position of the optical element along the alignment beam could be altered to adjust the focal plane of the alignment beam.

According to an embodiment the optical element is hollow and filled with a fluid, the composition of the fluid being adjustable to change the refractive index of the optical element. Optionally the refractive index of the optical element is changed by changing the salt concentration of the fluid or by changing the ratio of mixture of two fluids in the optical element, each fluid having a different refractive index.

The optical element can be used to adjust the focal plane of the alignment system in a direction parallel to the direction of propagation of the alignment beam i. e. the z direction. Alternatively, or additionally, the optical element adjusts the focal plane of the alignment system in a direction perpendicular to the direction of propagation of the alignment beam. This can be achieved by adjusting the angle of the optical element relative to the alignment beam or by adjusting the shape of the optical element.

The apparatus can include plurality of optical elements removably positionable in the path of the alignment beam such that one or more may be simultaneously in the path of the alignment beam.

The alignment system comprises an alignment projection system and the optical element can be placed in the alignment beam directly after an alignment projection system, directly before the alignment projection system, or be attached to the substrate table. If front-to-backside alignment optics are used to direct the alignment beam to the back of the substrate the optical element can be placed on the entrance to the front-to-backside alignment optics.

According to a further aspect of the invention there is provided a lithographic projection apparatus a radiation system for providing a projection beam of radiation, a support structure for supporting patterning means, the patterning means serving to pattern the projection beam according to a desired pattern, a projection system for projecting the patterned beam onto a target portion of the substrate; and an alignment tool as described above.

According to a further aspect of the invention there is provided an alignment method comprising the steps of: providing a substrate with a substrate mark which may be at a different level from the rest of the surface of the substrate, providing an alignment beam of radiation and providing an alignment system for projecting said alignment beam of radiation onto the substrate mark, characterized by adjusting the focal plane of said alignment beam to focus on said substrate mark at a different level from the rest of the surface of said substrate by interposing an optical element into the alignment beam while detecting alignment.

The optical element can adjust the focal plane of the alignment system by up to 2 mm. Furthermore, the optical element adjusts the focal plane of the alignment system by at least 0.1 mm.

According to a further aspect of the invention there is provided a device manufacturing method comprising the steps of: at least partially covering said substrate with a layer of radiation-sensitive material, providing a projection beam of radiation using a radiation system, using patterning means to endow the projection beam with a pattern in its cross-section, projecting the patterned beam of radiation onto a target portion of the layer of radiation-sensitive material, and an alignment method as described above.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet radiation (*e.g.* with a wavelength of 365, 248, 193, 157 or 126 nm) and EUV (extreme ultra-violet radiation, *e.g.* having a wavelength in the range 5-20 nm), as well as particle beams, such as ion beams or electron beams.

Embodiments of the invention will now be described, by way of example only, with reference to the accompanying schematic drawings in which:

Figure 1 depicts a lithographic projection apparatus according to an embodiment of the invention;

Figure 2 is a diagram showing the arrangement of an optical element in a lithographic apparatus according to an embodiment of the invention;

Figure 3 is a diagram showing an arrangement of an optical element for a deeper etched alignment mark;

Figure 4 is a diagram showing an arrangement of an optical element for use with front-to-backside alignment optics;

Figure 5 is a diagram showing an alternative arrangement of an optical element in a lithographic apparatus;

Figure 6 is a diagram showing another alternative arrangement of an optical element in a lithographic apparatus;

Figure 7 is a diagram showing an arrangement of an optical element to adjust the focus in an x and/or y direction;

Figure 8 is a diagram showing an alternative arrangement of an optical element to adjust the focus in an x and/or y direction;
Figure 9 is a diagram showing an arrangement of an optical element filled with fluid in a lithographic apparatus; and
Figure 10 shows the arrangement of an optical element in an alignment tool.

In the Figures, corresponding reference symbols indicate corresponding parts.

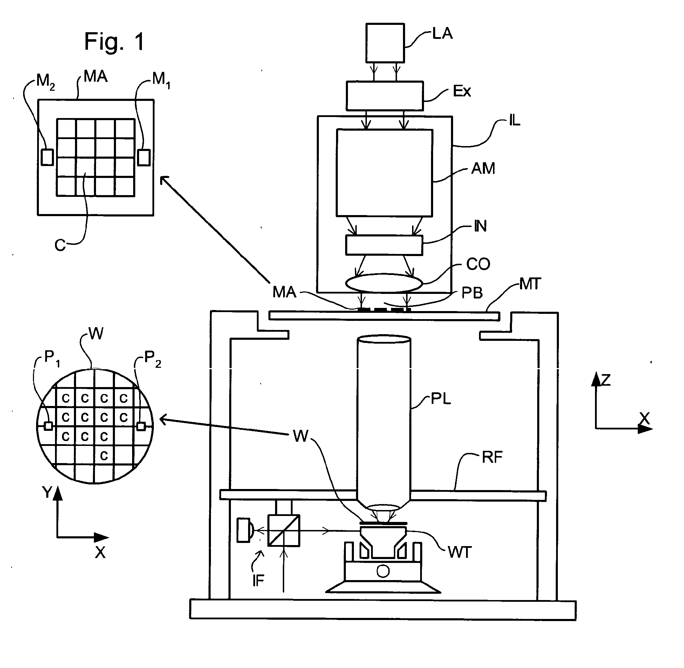

Figure 1 schematically depicts a lithographic projection apparatus according to a particular embodiment of the invention. The apparatus comprises:

- a radiation system Ex, IL, for supplying a projection beam PB of radiation (*e.g.* EUV radiation), which in this particular case also comprises a radiation source LA;
- a first object table (mask table) MT provided with a mask holder for holding a mask MA (*e.g.* a reticle), and connected to first positioning means for accurately positioning the mask with respect to item PL;
- a second object table (substrate table) WT provided with a substrate holder for holding a substrate W (*e. g.* a resist-coated silicon wafer), and connected to second positioning means for accurately positioning the substrate with respect to item PL;
- a projection system ("lens") PL (*e.g.* catadioptric lens system) for imaging an irradiated portion of the mask MA onto a target portion C (*e.g.* comprising one or more dies) of the substrate W.

As here depicted, the apparatus is of a transmissive type (*e.g.* has a transmissive mask). However, in general, it may also be of a reflective type, for example (*e.g.* with a reflective mask). Alternatively, the apparatus may employ another kind of patterning means, such as a programmable mirror array of a type as referred to above.

The source LA (*e.g.* a laser-produced or discharge plasma source) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to Figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. The current invention and Claims encompass both of these scenarios.

The beam PB subsequently intercepts the mask MA, which is held on a mask table MT. Having traversed the mask MA, the beam PB passes through the lens PL, which focuses the beam PB onto a target portion C of the substrate W. With the aid of the second positioning means (and interferometric measuring means IF), the substrate table WT can be moved accurately, *e.g.* so as to position different target portions C in the path of the beam PB. Similarly, the first positioning means can be used to accurately position the mask MA with respect to the path of the beam PB, *e.g.* after mechanical retrieval of the mask MA from a mask library, or during a scan. In general, movement of the object tables MT, WT will be realized with the aid of a long-stroke module (course positioning) and a short-stroke module (fine positioning), which are not explicitly depicted in Figure 1. However, in the case of a wafer stepper (as opposed to a step-and-scan apparatus) the mask table MT may just be connected to a short stroke actuator, or may be fixed.

The depicted apparatus can be used in two different modes:

1. In step mode, the mask table MT is kept essentially stationary, and an entire mask image is projected in one go (*i.e.* a single "flash") onto a target portion C. The substrate table WT is then shifted in the x and/or y directions so that a different target portion C can be irradiated by the beam PB;
2. In scan mode, essentially the same scenario applies, except that a given target portion C is not exposed in a single "flash". Instead, the mask table MT is movable in a given direction (the so-called "scan direction", *e.g.* the y direction) with a speed $\nu$, so that the projection beam PB is caused to scan over a mask image; concurrently, the substrate table WT is simultaneously moved in the same or opposite direction at a speed $V = M\nu$, in which $M$ is the magnification of the lens PL (typically, $M = 1/4$ or $1/5$). In this manner, a relatively large target portion C can be exposed, without having to compromise on resolution.

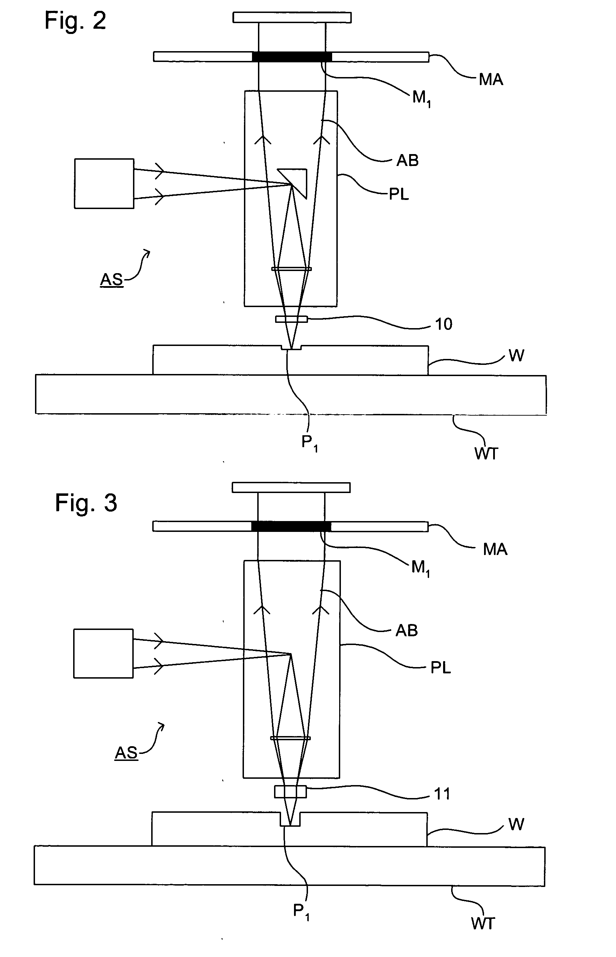

Prior to exposure of the substrate, alignment of the mask MA and substrate W takes place. Complementary alignment marks $M_1$, $M_2$ and substrate marks $P_1$, $P_2$ are present on the mask MA and substrate W respectively. In Figure 2 an alignment beam AB is projected through the projection system PL. As can be seen the substrate mark $P_1$ is in a pit in the top surface of the substrate W. To adjust the focal plane of the alignment beam AB to the level of the substrate mark $P_1$ an optical element 10 is inserted into the alignment beam after the projection system PL. In this example the optical element 10 used is a plane plate 10. However, convex or concave mirrors or other refractive elements could also be used. For a required optical path offset of $d_o$ generated by a material of refractive index $n_o$, the plane plate should have a thickness, $d_p$, given by $d_p = c.d_o$ where

$$c = \frac{n_1}{n_1 - n_0}$$

where $n_1$ is the refractive index of the plane plate 10.

The alignment beam is partially reflected from the substrate mark $P_1$ through the alignment system AS. The alignment beam is then imaged onto the alignment mark $M_1$. The alignment of the substrate mark $P_1$ and alignment mark $M_1$ can be detected in a known manner to determine the alignment of the substrate W.

In Figure 3 the substrate mark $P_1$ is in a deeper pit and a different plane plate 10 is therefore used to adjust the focal length. Here the plane plate is thicker, but a different shaped optical element could be used or a plane plate made of a material with different optical properties.

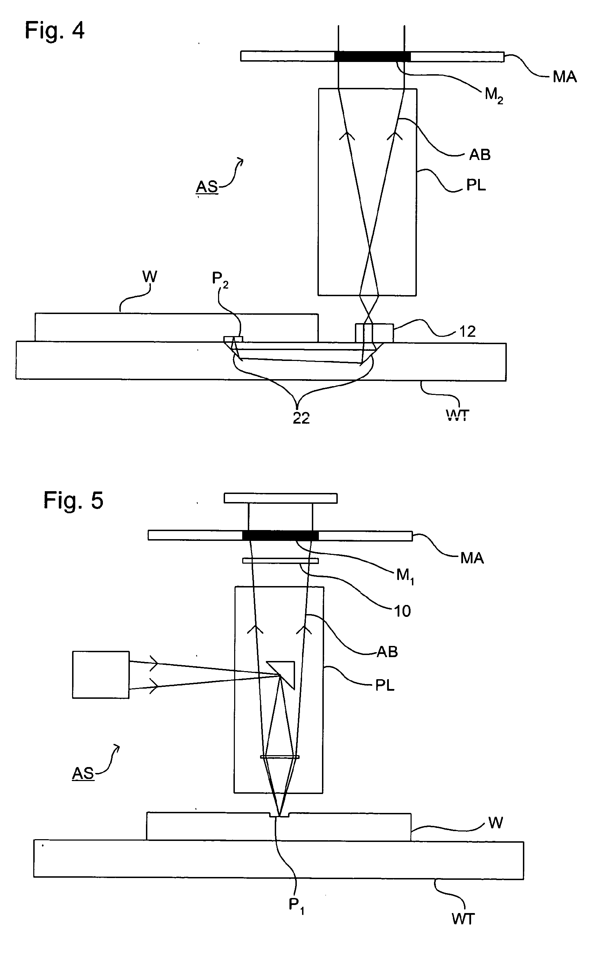

In Figure 4 the substrate mark $P_2$ is in a pit below the bottom surface of the substrate and so the optical path length of the alignment beam projected onto the bottom of the substrate by front-to-backside alignment optics 22 would differ from the optical path length of the alignment beam projected onto the substrate mark $P_2$. The substrate mark $P_2$ is re-imaged by the front-to-backside alignment optics 22 at the side of the substrate W. Optical element 12 compensates for the pit in which the substrate mark $P_2$ is in, and shifts the image to the same level as the front of the substrate W.

Figure 5 shows an embodiment of the invention in which the plane plate 10 is between the mask MA and the projection system PL.

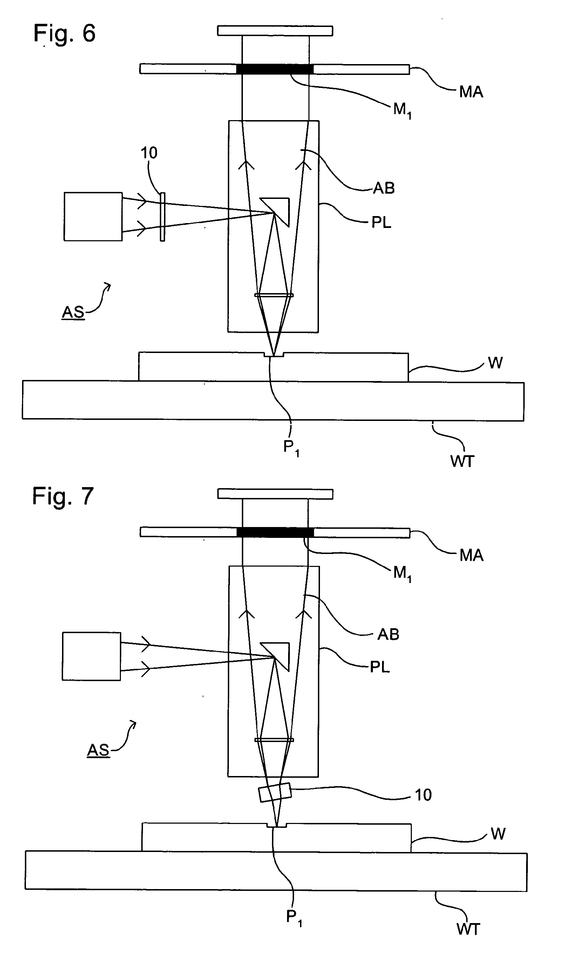

Figure 6 shows an embodiment of the invention in which the plane plate 10 is placed in the path of the alignment beam AB prior to the alignment beam being projected through the projection system PL.

In addition to offsetting the optical path in the z direction in the embodiments above the optical element 10 can also be used to adjust the optical path in other directions e.g. in the plane perpendicular to the z direction. As shown in Figure 7 the plane plate 10 is placed at an acute angle to the direction of propagation of the alignment beam AB. The alignment beam AB can thus be brought accurately into focus on a substrate mark $P_1$ shifted both in the z direction and in the x and/or y direction. The angle of the optical element 10 can be varied to adjust the focal plane in the x and/or y direction.

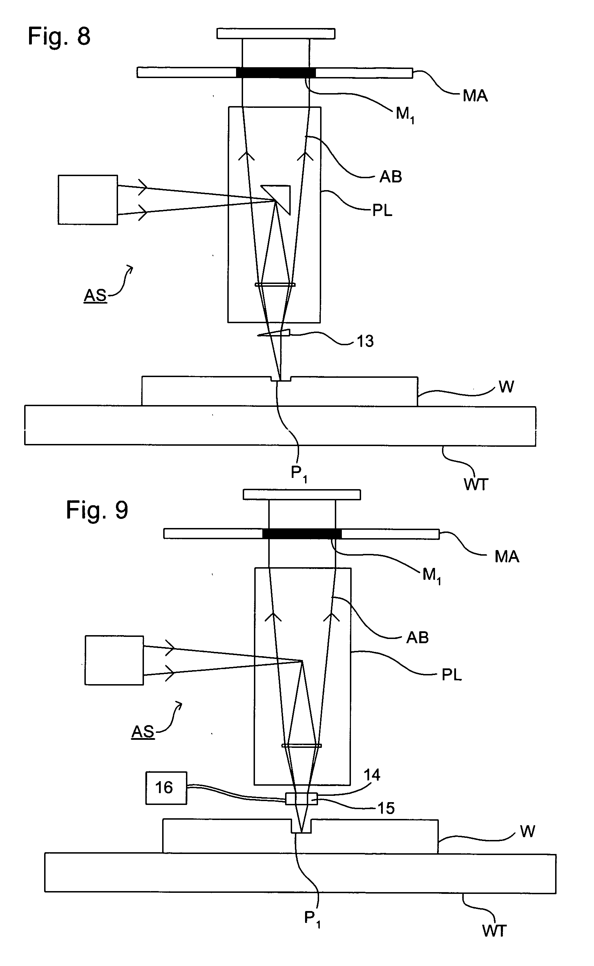

The x and/or y offset can also be achieved using optical elements other than plane plates. For example, a wedge shaped optical element 13 shown in Figure 8 is a compact and accurate way of generating an x or y offset: the optical element 13 can then simply be placed in the alignment beam without needing to precisely measure the angle optical element is placed at with respect to the alignment beam.

In an alternative embodiment the optical element 10 in the path of the alignment beam AB is of fixed thickness $d_p$ but the refractive index of the optical element 10 is varied. This could be achieved by replacing a plane plate made of, for example glass by a plane plate made of, for example, perspex. Alternatively, the optical element could be a hollow plane plate filled with a fluid of known refractive index. The refractive index of the optical element 10 is then varied by changing the composition of the fluid. As shown in Figure 9 the fluid 15 inside the optical element 14 can be replaced and the composition adjusted by the fluid replacement means 16. The composition can be adjusted by, for example, changing the salt concentration in the fluid or changing the ratio of two fluids in a mixture. The replacement and refreshment of the fluid 15 in the optical element 14 also keeps the optical element 14 cool, thus reducing errors and damage caused by thermal expansion and contraction of components.

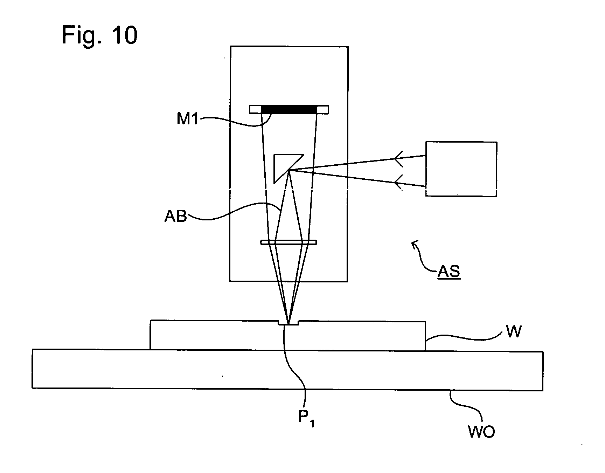

Figure 10 shows a separate alignment tool in which the alignment system AS is separate from projection system. The alignment system AS projects the alignment beam AB towards the substrate mark $P_1$ on the substrate W. In this embodiment the substrate W is on substrate table WO. The alignment beam is partially reflected from the substrate mark $P_1$ and imaged onto alignment mark $M_1$ to detect alignment. Such an alignment tool can be used in conjunction with a lithographic apparatus without means for aligning the substrate W. the substrate W is transferred between the substrate table WO of the alignment tool and the substrate table WT of the lithographic apparatus with sufficient precision to maintain the alignment accuracy.

For a larger focus offset a plurality of optical elements can be combined. Alternatively one optical element can be used to control the focus offset in the z direction and another used to control the focus offset in the x and y directions.

Whilst specific embodiments of the invention have been described above, it will be appreciated that the invention may be practiced otherwise than as described. The description is not intended to limit the invention.

**Claims**

1. An alignment tool comprising:

   - a substrate table for holding a substrate having a substrate mark wherein the substrate mark may be at a different level from the rest of the surface of said substrate; and
   - an alignment system for detecting alignment between a reference mark and said substrate mark using an alignment beam of radiation,

**characterized by** an optical element removably positionable in the path of the alignment beam for adjusting the focal plane of said alignment system to focus on said substrate mark at a different level from the rest of the surface of said substrate when detecting alignment.

2. An alignment tool according to claim 1 wherein the optical element is a plane plate.

3. An alignment tool according to either claim 1 or claim 2 wherein said optical element adjusts the focal plane of said alignment system by up to 2 mm.

4. An alignment tool according to any one of the preceding claims wherein said optical element adjusts the focal plane of said alignment system by at least 0.1 mm.

5. An alignment tool according to any one of claims 1 to 4 wherein the alignment system comprises a projection alignment system and the optical element is placed in the alignment beam directly after the projection alignment system.

6. An alignment tool according to any one of claims 1 to 4 wherein the optical element is attached to the substrate table.

7. An alignment tool according to any one of claims 1 to 4 further comprising front-to-backside alignment optics which direct the alignment beam to the back of the substrate and in which the optical element is placed on the entrance to the front-to-backside alignment optics.

8. An alignment tool according to any one of the preceding claims wherein the position of the optical element along the projection beam is altered to adjust the focal plane of the projection beam.

9. An alignment tool according to any one of the preceding claims wherein there are a plurality of interchangeable optical elements.

10. An alignment tool according claim 9 wherein the plurality of interchangeable optical elements have different thicknesses.

11. An alignment tool according to claim 9 or claim 10 wherein the plurality of interchangeable optical element have different optical properties.

12. An alignment tool according to claim 11 wherein the different optical properties are different refractive indices.

13. An alignment tool according to claim 12 wherein said optical elements are hollow, each optical element being filled with a fluid having a different refractive index.

14. An alignment tool according to any one of the preceding claims wherein said optical element is hollow and filled with a fluid, the composition of the fluid being adjustable to change the refractive index of the optical element.

15. An alignment tool according to claim 14 wherein said fluid wherein the refractive index of said optical element is changed by changing the salt concentration of said fluid.

16. An alignment tool according to claim 14 or claim 15 wherein the refractive index of said optical element is changed by changing the ratio of mixture of two fluids in said optical element, each fluid having a different refractive index.

17. An alignment tool according to any one of the preceding claims wherein there are a plurality of optical elements removably positionable in the path of the alignment beam such that one or more may be simultaneously in the path of the alignment beam.

18. An alignment tool according to any one of the preceding claims wherein said optical element adjusts the focal plane of the alignment system in a direction parallel to the direction of propagation of said alignment beam.

19. An alignment tool according to any one of the preceding claims wherein said optical element adjusts the focal plane of the alignment system in a direction perpendicular to the direction of propagation of said alignment beam.

20. A lithographic projection apparatus comprising:

- a radiation system for providing a projection beam of radiation;
- a support structure for supporting patterning means, the patterning means serving to pattern the projection beam according to a desired pattern;
- a projection system for projecting the patterned beam onto a target portion of the substrate; and
- an alignment tool according to any one of the preceding claims.

21. An apparatus according to claim 20, wherein the alignment beam traverses at least part of the projection system.

22. An alignment method comprising the steps of:

- providing a substrate with a substrate mark which may be at a different level from the rest of the surface of the substrate;
- providing an alignment beam of radiation; and
- providing an alignment system for projecting said alignment beam of radiation onto the substrate mark;

**characterized by** adjusting the focal plane of said alignment beam to focus on said substrate mark at a different level from the rest of the surface of said substrate by interposing an optical element into the alignment beam while detecting alignment.

23. A device manufacturing method comprising the steps of:

- at least partially covering said substrate with a layer of radiation-sensitive material;
- providing a projection beam of radiation using a radiation system;
- using patterning means to endow the projection beam with a pattern in its cross-section;
- projecting the patterned beam of radiation onto a target portion of the layer of radiation-sensitive material; and
- an alignment method according to claim 22.

# Fig. 1

Fig. 2

MA

M₁

AB

PL

AS

10

W

P₁

WT

Fig. 3

MA

M₁

AB

PL

AS

11

W

P₁

WT

Fig. 4

Fig. 5

Fig. 6

MA

M₁

10

AB

PL

AS

W

P₁

WT

Fig. 7

MA

M₁

AB

PL

AS

10

W

P₁

WT

Fig. 8

Fig. 9

Fig. 10